# EUROPEAN PATENT SPECIFICATION

(11) **EP 4 391 203 B1**
(45) Date of publication and mention of the grant of the patent: **28.10.2026**
(21) Application number: 22932493.4
(22) Date of filing: 01.12.2022
(51) Int. Cl.: H01M 50/519, H01M 50/209, H01M 50/244, H05K 1/189, H01M 50/507, H05K 1/18, H01M 10/42, H05K 1/02, H01M 50/284, H01M 50/258, H01M 50/213

(54) **BATTERY MODULE**
BATTERIEMODUL
MODULE DE BATTERIE

(30) Priority: 07.11.2022 CN 202222956571 U
(43) Date of publication of application: 26.06.2024
(73) Proprietor: Eve Power Co., Ltd., Jingmen, Hubei 448000 (CN)
(72) Inventor: REN, Chaoju, Jingmen, Hubei 448000 (CN); LU, Jungao, Jingmen, Hubei 448000 (CN); ZHANG, Guojiang, Jingmen, Hubei 448000 (CN); XU, Yuhong, Jingmen, Hubei 448000 (CN); JIANG, Jibing, Jingmen, Hubei 448000 (CN)
(74) Representative: Petraz, Gilberto Luigi
(86) International application number: PCT/CN2022/135749
(87) International publication number: WO 2024/098478

(56) References cited:
- EP-A1- 3 940 862
- EP-A2- 3 565 021
- CN-U- 211 530 005
- CN-U- 213 340 487
- CN-U- 213 816 347
- CN-U- 214 313 459
- CN-U- 216 251 013
- CN-U- 217 656 040
- KR-A- 20190 027 096
- US-A1- 2019 131 672
- US-A1- 2020 220 122

## Description

### TECHNICAL FIELD

The present application relates to the field of battery technologies, and for example to a battery module.

### BACKGROUND

The smallest unit of a power battery is a cell. One power battery includes hundreds of individual cells, where a group of cells may form a battery module, and a plurality of battery modules may form the power battery. In order to fix position of the cells, the battery module is generally provided with a mounting bracket, and assembling of the battery module includes fixing structural members such as cells, an Flexible Printed Circuit (FPC) board, an acquisition wiring harness, a connector, and a busbar to the mounting bracket. If these structural members are all separately fed, it will result in an increase in the types of materials, an increase in the difficulty of material management and control, and an impact on assembly efficiency and product quality at an assembling station of the battery module.

In addition, the connector is generally installed in a manner of snap connection for the battery module in the related art and fixed to the mounting bracket by the snap. Since the snap is easily loosened and vibration of the battery module in use may cause the connector to shake, resulting in a poor acquisition contact and affecting reliability of the battery module. US2019131672A1 discloses a battery module, including: a plurality of battery cells within a cell retention frame; a plurality of collector structures, each collector structure electrically interconnecting a plurality of said battery cells proximate a top side or bottom side of said cell retention frame; a battery management circuit including a voltage monitor; and one or more monitoring flexible printed circuits (FPCs), each monitoring FPC electrically interconnecting the battery management circuit with one or more of the collector structures.
KR20190027096A discloses a battery cell module, which includes: a cell assembly having at least one battery cell; an upper plate positioned above the cell assembly and formed with a recessed protecting portion; side plates each having one end folded to be coupled at both side edges in a width direction of the upper plate and having a busbar attached to an outer side thereof; a flexible printed circuit board received in the protection portion formed on the upper plate and fixed by an adhesive and including a temperature sensing portion which is in contact with the cell assembly and a voltage sensing portion which is in close contact with the busbar; and a pressing plate covering both ends of the flexible printed circuit board and closely fixed to the side plates.
EP3565021A2 discloses a bus bar assembly installed in a frame for fixing a plurality of stacked battery cells, where the bus bar assembly may include: a bus bar fixed to the frame; a flexible printed circuit board electrically connected to the bus bar and configured to sense the plurality of battery cells; and a connection terminal having a protrusion formed on one surface of the connection terminal, is the protrusion being configured to pass through the flexible printed circuit board so as to be electrically connected to the flexible printed circuit board, and the connection terminal configured to be electrically connected to the bus bar through the opposite surface of the one surface, the opposite surface being bonded to the bus bar.
US2020220122A1 discloses a cell holder structure for holding a plurality of rechargeable battery cells, including: a holder base part and a holder cover part which is connectable to the latter, the holder base part and holder cover part together forming an array of cell-receiving spaces and cell intermediate spaces lying inbetween, where the holder base part has one or more base side cell supporting pillars which extend axially from a base plane of the holder base part into assigned cell intermediate spaces and have a circumferential side securing wall region configured for abutting in an axially and radially position securing manner against a circumferential surface of rechargeable battery cells to be accommodated in the cell receiving spaces, and/or the holder cover part has one or more cover side cell-supporting pillars which extend axially from a cover plane of the holder cover part into the cell intermediate spaces and have a circumferential side securing wall region configured for abutting in an axially and radially position securing manner against a circumferential surface of the rechargeable battery cells.
CN213340487U discloses a battery module, where the battery module includes a module body and an acquisition device, where the module body includes at least two battery monomers, all the battery monomers are sequentially arranged along a first direction, and two opposite ends of each battery monomer are respectively provided with tabs with opposite polarities, the acquisition device includes two FPC main bodies arranged on one side of the module body, the two FPC main bodies are distributed at intervals along a second direction, one end of each of the two FPC main bodies is connected with the battery management system through a wire bank, each of the two FPC main bodies is provided with a first FPC branch corresponding to the battery monomer, the first FPC branches are electrically connected with tabs corresponding to the battery monomer through voltage acquisition sheets, and the first FPC branches are electrically connected with the tabs corresponding to the battery monomer through voltage acquisition sheets. CN211530005U discloses an electric vehicle battery module and a busbar for the battery module. The utility model relates to the technical field of electromobile batteries. The battery includes a battery frame body, battery cells, partition plates and an upper cover, the battery cell is placed in the battery frame body; a busbar is arranged above the positive electrode of the battery cell; where the battery frame body includes an upper bracket and a lower bracket; where a plurality of battery cells are arranged between the upper bracket and the lower bracket, supporting plates are respectively arranged at four corners of the upper bracket and the lower bracket, fixing holes penetrating up and down are formed in the supporting plates, the whole battery module is fixed on a battery pack shell through fasteners in the fixing holes, two side edges of each supporting plate extend outwards, and reinforcing ribs are arranged at extending parts.

### SUMMARY

The invention is set out in the appended set of claims.

### BRIEF DESCRIPTION OF THE DRAWINGS

FIG. 1 is a first schematic structural diagram of a battery module according to some embodiments of the present application.
FIG. 2 is a second schematic structural diagram of a battery module according to some embodiments of the present application.
FIG. 3 is a partially enlarged view of a portion A of the battery module in FIG. 1.
FIG. 4 is a partially enlarged view of a portion B of the battery module in FIG. 2.
FIG. 5 is a schematic structural diagram of a negative output busbar according to some embodiments of the present application.
FIG. 6 is a first schematic structural diagram of a mounting bracket according to some embodiments of the present application.
FIG. 7 is a partially enlarged view of a portion C of the battery module in FIG. 6.
FIG. 8 is a second schematic structural diagram of a mounting bracket according to some embodiments of the present application.
FIG. 9 is a partially enlarged view of a portion D of the battery module in FIG. 8.

In FIGS:
1. Mounting bracket; 11. First mounting surface; 12. Second mounting surface; 13. Fixing plate; 131. Riveting post; 14. Reinforcing rib; 15. First limiting member; 16. Second limiting member; 2. Busbar assembly; 21. Negative output busbar; 211. Bent output end; 2111. Mounting hole; 212. Connection bolt; 3. Cell; 4. FPC board assembly; 40. Positioning hole; 41. FPC board; 411. Connection end; 412. First FPC board; 413. Second FPC board; 42. Connector; 43. Reinforcing plate.

### DETAILED DESCRIPTION

In description of the present application, it should be noted that the terms "interconnection", "connection" and "fixing" should be understood in a broad sense, unless otherwise clearly specified. For example, "fixing" can be a fixed connection, a detachable connection, or integrated connection. It can be a mechanical connection or an electrical connection. It can be directly connected or indirectly connected through an intermediary. It can also be the connection between two elements or the interaction between two elements. Those ordinary skilled in the art can understand the meanings of the above terms in the present application according to actual situations.

In the present application, it should he noted that unless otherwise clearly specified, a first feature "on" or "under" a second feature may mean that the first feature directly contacts the second feature, or that the first feature contacts the second feature via an additional feature there between instead of directly contacting the second feature. Moreover, the first feature "on", "above", and "over" the second feature may mean that the first feature is right over or obliquely upward over the second feature or mean that the first feature has a horizontal height higher than that of the second feature. The first feature "under", "below", and "beneath" the second feature may mean that the first feature is right beneath or obliquely downward beneath the second feature or mean that horizontal height of the first feature is lower than that of the second feature.

In the description of the embodiments, orientations or position relationships indicated by the terms "upper", "lower", "left", "right" are based on orientations or position relationships illustrated in the drawings. The terms are used to facilitate the description and simplify the operations, rather than indicate or imply that the devices or elements referred to herein are required to have specific orientations or be constructed or operate in the specific orientations. In addition, the terms "first" and "second" are used solely for the purpose of distinguishing elements in terms of description of the elements and not in a particular sense.

The smallest unit of a power battery is a cell. The power battery includes hundreds of individual cells, where a group of cells may form a battery module, and a plurality of battery modules may form the power battery. The assembling of the battery module includes fixing the structural members such as the cells, the FPC board, the acquisition wiring harness, the connector, and the busbar to the mounting bracket. If these structural members are all separately fed, it will result in the increase in the types of materials, the increase in the difficulty of material management and control, and the impact on the assembly efficiency and the product quality at the assembling station of the battery module. If the structural members such as the FPC board, the connector, and the busbar, and the mounting bracket are integrally assembled and fed together in a preceding working procedure, the FPC board and the busbar occupy a larger space area, and is easily interfered with the fixing mounting of the cells. It is also necessary to disassemble the FPC board, and then assemble the FPC board to the mounting bracket after completing installation of the cells, thereby adding additional process and seriously affecting the mounting efficiency.

In addition, the connector is generally installed in a manner of snap connection for the battery module in the related art and fixed to the mounting bracket by the snap. Since the snap is easily loosened and vibration of the battery module in use may cause the connector to shake, resulting in the poor acquisition contact and affecting reliability of the battery module. In order to solve the above technical problems, embodiments of the present application provide a battery module.

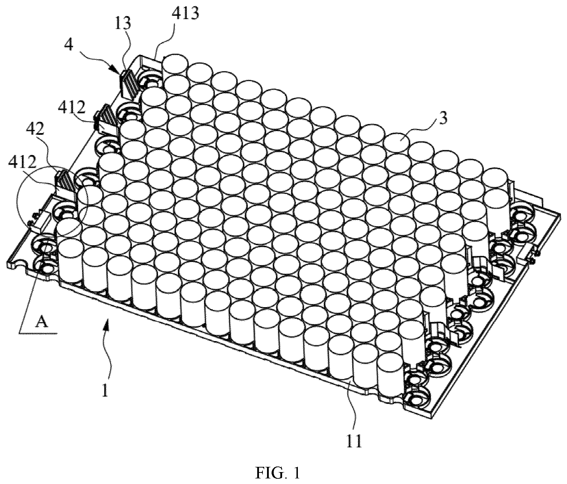

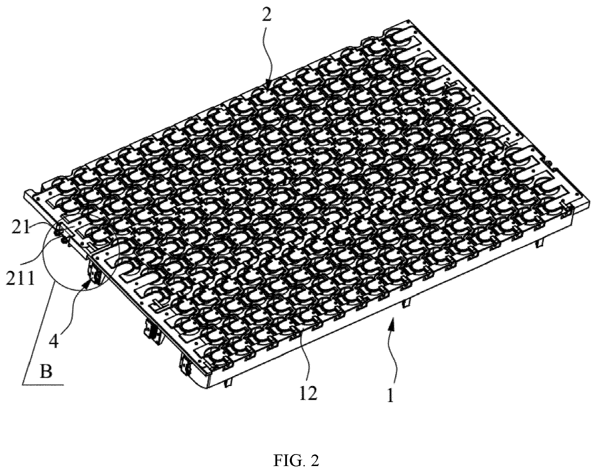

As shown in FIGS. 1 to 9, embodiments of the present application provide a battery module, including a mounting bracket 1, a bus bar assembly 2, a plurality of cells 3, and an FPC board assembly 4. The mounting bracket 1 includes a first mounting surface 11 and a second mounting surface 12 disposed opposite to each other 1, where the first mounting surface 11 is provided with a plurality of fixing plates 13. The busbar assembly 2 is detachably connected to the mounting bracket 1 and disposed on the second mounting surface 12. The plurality of cells 3 are arranged on the first mounting surface 11 and connected to the bus bar assembly 2. The FPC board assembly 4 includes a plurality of FPC boards 41 and a plurality of connectors 42. The FPC boards 41 are vertically arranged on the first mounting surface 11, and thus the FPC boards 41 do not affect the assembling of the cells 3, so that the busbar assembly 2, the mounting bracket 1, and the FPC board assembly 4 can be pre-assembled in advance. The busbar assembly 2, the mounting bracket 1, and the FPC board assembly 4 are assembled in the preceding working procedure, so that the integrated feeding is realized at the assembling station of the cells 3, the types of the materials are reduced, difficulty of the material management and control is reduced, the occupation of equipment and a field is reduced, and the assembly efficiency and the product quality are improved.

A connection end 411 of each of the FPC boards 41 is fixedly connected to respective one of the connectors 42 and riveted to respective one of the fixing boards 13, so that installation of the connector 42 is implemented. Alternatively, the mounting bracket 1 is manufactured from a plastic material, and is easily riveted to the connection end 411 by a hot riveting connection. The manufacturing process is simple, the manufacturing cost is low, the fixing is reliable, and no looseness is generated. The vibration of the battery module in use makes it difficult to cause the vibration of the connector 42, thereby avoiding poor acquisition contact and ensuring the working reliability of the battery module.

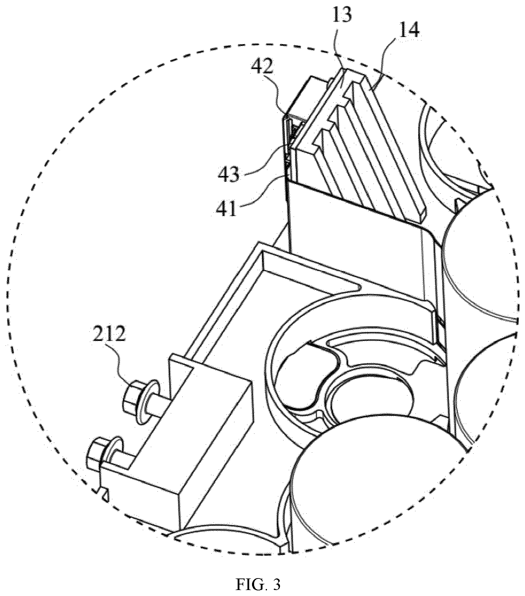

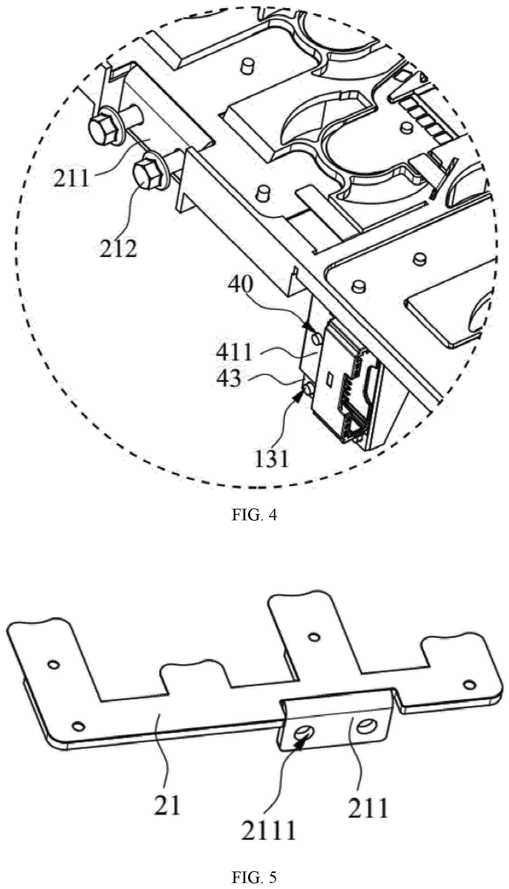

In an embodiment, the FPC board assembly further includes a plurality of reinforcing plates 43. As shown in FIGS. 3 and 4, each of the reinforcing plates 43 is connected to a side of respective one of the connection ends 411 away from respective one of the connectors 42 and riveted to respective one of the fixing plates 13. The reinforcing plate 43 is capable of increasing the strength of the connection end 411 and fixing the connector 42 more firmly. Illustratively, the fixing plate 13 is provided with a plurality of riveting posts 131, the reinforcing plate 43 and the connection end 411 both are provided with a plurality of positioning holes 40 through which the riveting posts 131 can pass and be riveted to the reinforcing plate 43 and the connection end 411.

In an embodiment, the mounting bracket 1 further includes a plurality of reinforcing ribs 14. As shown in FIG. 3, each of the reinforcing ribs 14 is connected to a side of respective one of the fixing plates 13 away from respective one of the connection ends 411. The mounting bracket 1 of the present embodiment is provided with four reinforcing ribs 14, which are parallel to each other and arranged at intervals. One end of the reinforcing rib 14 is connected to one side of the fixing plate 13 away from the connection end 411, and the other end of the reinforcing rib 14 is connected to the first mounting surface 11. The reinforcing ribs 14 can increase the strength of the mounting bracket 1 and prevent the mounting of the FPC board assembly 4 from being insufficient.

In an embodiment, the busbar assembly 2 includes a negative output busbar 21. As shown in FIG. 5, the negative output busbar 21 includes a bent output end 211 parallel to an axial direction of the cells 3 and configured to connect an adjacent battery module. Illustratively, the bent output end 211 is attached to the mounting bracket 1 and provided with a connection bolt 212, an axial direction of the connection bolt 212 is perpendicular to a side surface of the mounting bracket 1, and the connection bolt 212 is configured to connect the adjacent battery module and screwed to a mounting hole 2111 of the bent output end 211. The bent output end 211 is formed by a sheet metal bending process, and the length of the bent output end 211 extends along the axial direction of the cells 3. Therefore, the bent output end 211 does not increase the length of each of the cells 3 in the horizontal direction, thereby reducing space occupation. When the battery module is connected to the adjacent battery module, the battery module and the adjacent battery module can be tightened by the connection bolt 212 in the horizontal direction, thereby greatly increasing the space utilization rate.

In an embodiment, the plurality of FPC boards 41 include a first FPC board 412 embedded among the plurality of cells 3 and a second FPC board 413 disposed around an outer periphery of the cells 3. The battery module of the present embodiment includes two first FPC boards 412 and one second FPC board 413. The two first FPC boards 412 are penetrated among the plurality of cells 3 to reduce the space occupation and do not block the first mounting surface 11 or the second mounting surface 12, and do not affect a welding connection between each of the cells 3 and the busbar assembly 2, thereby facilitating the integrated feeding.

In an embodiment, the first FPC board 412 includes a bent extension portion capable of attaching a side of the plurality of cells 3. The bent extension portion has a wavy cross section and easily attaches an outer surface of a cylindrical cell 3. The first FPC plate 412 extends in a straight line at both ends of the bent extension portion to facilitate the fixing.

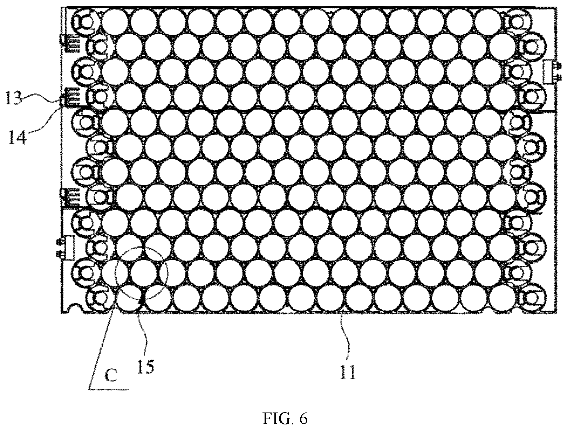

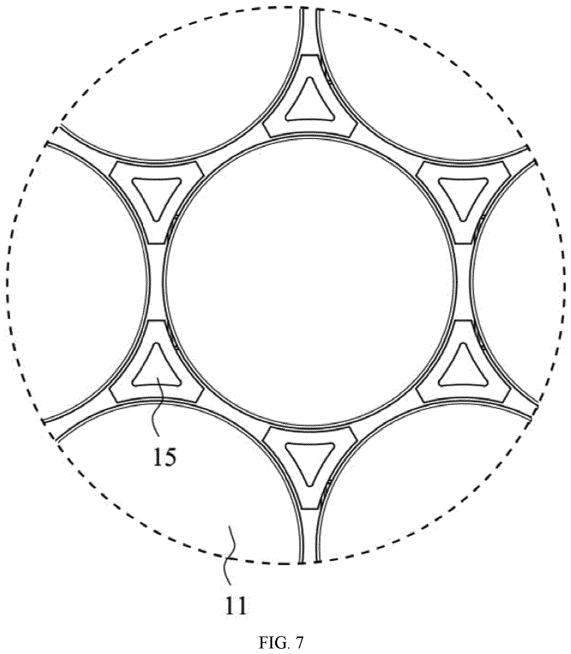

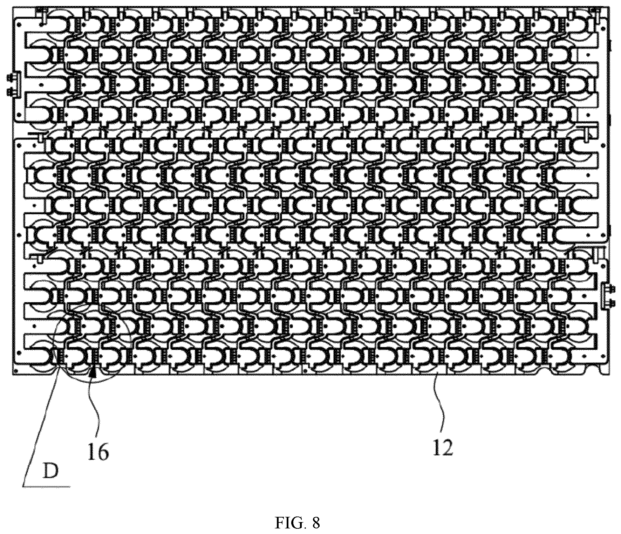

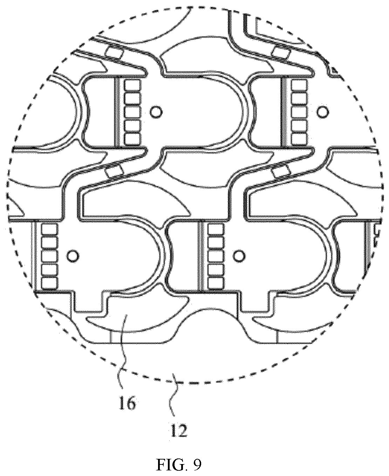

In an embodiment, the mounting bracket 1 includes a plurality of first limiting members 15. As shown in FIGS. 6 and 7, the first limiting members 15 are protruded on the first mounting surface 11 and configured to snap-fit the cells 3. Illustratively, the mounting bracket 1 further includes a plurality of second limiting members 16. As shown in FIGS. 8 and 9, the second limiting members 16 are protruded on the second mounting surface 12 and configured to snap-fit the busbar assembly 2. In the present embodiment, each of the cells 3 is cylindrical in shape, and each of the first limiting members 15 is composed of six protrusions with arc surfaces, where the protrusions are protruded on the first mounting surface 11, and the arc surfaces of the six protrusions are provided concentrically, so that the protrusions can be attached to the cell 3, the positioning accuracy of the cell 3 is increased, and the assembly efficiency of the cell 3 is improved. Each of the second limiting members 16 is designed according to an appearance shape of the bus bar assembly 2 and consists of a plurality of protrusions including curved surfaces and flat surfaces. Of course, in other embodiments, the configuration of the first limiting members 15 and the second limiting members 16 may vary depending on the appearance shapes of the cell 3 and the busbar assembly 2.

## Claims

1. A battery module, comprising:
a mounting bracket (1) comprising a first mounting surface (11) and a second mounting surface (12) disposed opposite to each other, wherein the first mounting surface (11) is provided with a plurality of fixing plates (13);
a busbar assembly (2) detachably connected to the mounting bracket (1) and disposed on the second mounting surface (12);
a plurality of cells (3) arranged on the first mounting surface (11) and connected to the busbar assembly (2); and
an Flexible Printed Circuit (FPC) board assembly (4) comprising a plurality of FPC boards (41) and a plurality of connectors (42), wherein the FPC boards (41) are vertically disposed on the first mounting surface (11), and a connection end (411) of each of the FPC boards (41) is fixedly connected to respective one of the connectors (42) and riveted to respective one of the fixing plates (13);
**characterized in that** the plurality of FPC boards (41) comprise a first FPC board (412) embedded among the plurality of cells (3) and a second FPC board (413) disposed around an outer periphery of the cells (3); and
wherein the first FPC board comprises a bent extension portion capable of attaching a side surface of each of the plurality of cells (3).

2. The battery module of claim 1, wherein the FPC board assembly further comprises a plurality of reinforcing plates (43), each of the reinforcing plates (43) is connected to a side of respective one of the connection ends (411) away from respective one of the connectors and riveted to respective one of the fixing plates (13).

3. The battery module of claim 2, wherein the fixing plate (13) is provided with a plurality of riveting posts (131), the reinforcing plate (43) and the connection end (411) both are provided with a plurality of positioning holes (40), and each of the riveting posts (131) is able to pass through respective one of the positioning holes (40) and riveted to the reinforcing plate (43) and the connection end (411).

4. The battery module of claim 1, wherein the mounting bracket (1) further comprises a plurality of reinforcing ribs (14) connected to a side of the fixing plates (13) away from the connection ends (411).

5. The battery module of claim 1, wherein the busbar assembly (2) comprises a negative output busbar (21), and the negative output busbar (21) comprises a bent output end (211) parallel to an axial direction of the cells (3) and configured to connect an adjacent battery module.

6. The battery module of claim 5, wherein the bent output end (211) is attached to the mounting bracket (1) and provided with a connection bolt (212), an axial direction of the connection bolt (211) is perpendicular to a side surface of the mounting bracket (1), and the connection bolt (212) is configured to connect the adjacent battery module and screwed to a mounting hole (2111) of the bent output end (211).

7. The battery module of any of claims 1-6, wherein the mounting bracket (1) comprises a plurality of first limiting members (15) protruded on the first mounting surface (11) and configured to snap-fit the cells (3).

8. The battery module of any of claims 1-6, wherein the mounting bracket (1) comprises a plurality of second limiting members (16) protruded on the second mounting surface (12) and configured to snap-fit the busbar assembly (2).

## Patentansprüche

1. Ein Batteriemodul, bestehend aus:
eine Halterung (1), die eine erste Befestigungsfläche (11) und eine zweite Befestigungsfläche (12) umfasst, die einander gegenüberliegend angeordnet sind, wobei die erste Befestigungsfläche (11) mit einer Vielzahl von Befestigungsplatten (13) versehen ist;
eine Sammelschienenbaugruppe (2), die lösbar mit der Halterung (1) verbunden ist und auf der zweiten Befestigungsfläche (12) angeordnet ist;
eine Vielzahl von Zellen (3), die auf der ersten Befestigungsfläche (11) angeordnet und mit der Sammelschienenbaugruppe (2) verbunden sind; und
eine Baugruppe (4) aus flexiblen Leiterplatten (FPC), die eine Vielzahl von FPC-Leiterplatten (41) und eine Vielzahl von Steckverbindern (42) umfasst, wobei die FPC-Leiterplatten (41) vertikal auf der ersten Befestigungsfläche (11) angeordnet sind, und ein Verbindungsende (411) jeder der FPC-Leiterplatten (41) fest mit einem jeweiligen der Steckverbinder (42) verbunden und an einer jeweiligen der Befestigungsplatten (13) vernietet ist;
**dadurch gekennzeichnet, dass** die mehreren FPC-Leiterplatten (41) eine erste FPC-Leiterplatte (412), die zwischen den mehreren Zellen (3) eingebettet ist, und eine zweite FPC-Leiterplatte (413), die um einen Außenumfang der Zellen (3) herum angeordnet ist, umfassen; und
wobei die erste FPC-Leiterplatte einen gebogenen Verlängerungsabschnitt aufweist, der zur Befestigung an einer Seitenfläche jeder der mehreren Zellen (3) geeignet ist.

2. Das Batteriemodul nach Anspruch 1, wobei die FPC-Leiterplattenbaugruppe ferner eine Vielzahl von Verstärkungsplatten (43) umfasst, wobei jede der Verstärkungsplatten (43) mit einer Seite des jeweiligen Verbindungsendes (411) verbunden ist, die von dem jeweiligen Steckverbinder abgewandt ist, und an der jeweiligen Befestigungsplatte (13) vernietet ist.

3. Das Batteriemodul nach Anspruch 2, wobei die Befestigungsplatte (13) mit einer Vielzahl von Nietstiften (131) versehen ist, die Verstärkungsplatte (43) und das Verbindungsende (411) jeweils mit mehreren Positionierungslöchern (40) versehen sind und jeder der Nietstifte (131) durch jeweils eines der Positionierungslöcher (40) geführt und an der Verstärkungsplatte (43) sowie am Verbindungsende (411) vernietet werden kann.

4. Das Batteriemodul nach Anspruch 1, wobei die Halterung (1) ferner eine Vielzahl von Verstärkungsrippen (14) umfasst, die mit einer von den Verbindungsenden (411) abgewandten Seite der Befestigungsplatten (13) verbunden sind.

5. Batteriemodul nach Anspruch 1, wobei die Sammelschienenbaugruppe (2) eine negative Ausgangs-Sammelschiene (21) umfasst und die negative Ausgangs-Sammelschiene (21) ein gebogenes Ausgangsende (211) aufweist, das parallel zur axialen Richtung der Zellen (3) verläuft und so ausgebildet ist, dass es ein benachbartes Batteriemodul verbindet.

6. Batteriemodul nach Anspruch 5, wobei das gebogene Ausgangsende (211) an der Halterung (1) befestigt und mit einer Verbindungsschraube (212) versehen ist, wobei die Axialrichtung der Verbindungsschraube (211) senkrecht zu einer Seitenfläche der Halterung (1) verläuft, und die Verbindungsschraube (212) so ausgebildet ist, dass sie das benachbarte Batteriemodul verbindet, und in ein Befestigungsloch (2111) des gebogenen Ausgangsendes (211) eingeschraubt ist.

7. Das Batteriemodul gemäß einem der Ansprüche 1 bis 6, wobei die Halterung (1) mehrere erste Begrenzungselemente (15) aufweist, die von der ersten Befestigungsfläche (11) vorstehen und so ausgebildet sind, dass sie die Zellen (3) einrasten lassen.

8. Batteriemodul nach einem der Ansprüche 1 bis 6, wobei die Halterung (1) mehrere zweite Begrenzungselemente (16) aufweist, die von der zweiten Befestigungsfläche (12) vorstehen und so ausgebildet sind, dass die Sammelschienenbaugruppe (2) in sie einrastet.

## Revendications

1. Module de batterie, comprenant :
un support de fixation (1) comprenant une première surface de fixation (11) et une deuxième surface de fixation (12) disposées en vis-à-vis l'une de l'autre, la première surface de fixation (11) étant pourvue d'une pluralité de plaques de fixation (13) ;
un ensemble de barres omnibus (2) relié de manière amovible au support de fixation (1) et disposé sur la deuxième surface de fixation (12) ;
une pluralité de cellules (3) disposées sur la première surface de fixation (11) et reliées à l'ensemble de barres omnibus (2) ; et
un ensemble de cartes de circuits imprimés flexibles (FPC) (4) comprenant une pluralité de cartes FPC (41) et une pluralité de connecteurs (42), dans lequel les cartes FPC (41) sont disposées verticalement sur la première surface de fixation (11), et une extrémité de connexion (411) de chacune des cartes FPC (41) est reliée de manière fixe à l'un des connecteurs (42) respectifs et rivetée à l'une des plaques de fixation (13) respectives ;
**caractérisé en ce que** la pluralité de cartes FPC (41) comprend une première carte FPC (412) intégrée parmi la pluralité de cellules (3) et une deuxième carte FPC (413) disposée autour d'une périphérie extérieure des cellules (3) ; et
dans lequel la première carte FPC comprend une partie d'extension courbée permettant de fixer une surface latérale de chacune des différentes cellules (3).

2. Module de batterie selon la revendication 1, dans lequel l'ensemble de cartes FPC comprend en outre une pluralité de plaques de renfort (43), chacune desdites plaques de renfort (43) étant reliée à un côté de l'une des extrémités de connexion (411) respectives, à l'opposé de l'un des connecteurs respectifs, et rivetée à l'une des plaques de fixation (13) respectives.

3. Module de batterie selon la revendication 2, dans lequel la plaque de fixation (13) est pourvue d'une pluralité de tiges de rivetage (131), la plaque de renfort (43) et l'extrémité de connexion (411) sont toutes deux pourvues d'une pluralité de trous de positionnement (40), et chacune des tiges de rivetage (131) peut traverser l'un des trous de positionnement (40) respectifs et être rivetée à la plaque de renfort (43) et à l'extrémité de connexion (411).

4. Module de batterie selon la revendication 1, dans lequel le support de fixation (1) comprend en outre une pluralité de nervures de renfort (14) reliées à un côté des plaques de fixation (13) opposé aux extrémités de connexion (411).

5. Module de batterie selon la revendication 1, dans lequel l'ensemble de barres omnibus (2) comprend une barre omnibus de sortie négative (21), et ladite barre omnibus de sortie négative (21) comprend une extrémité de sortie coudée (211) parallèle à la direction axiale des cellules (3) et configurée pour se connecter à un module de batterie adjacent.

6. Module de batterie selon la revendication 5, dans lequel l'extrémité de sortie coudée (211) est fixée au support de fixation (1) et munie d'un boulon de raccordement (212), la direction axiale du boulon de raccordement (211) étant perpendiculaire à une surface latérale du support de fixation (1), et le boulon de raccordement (212) est conçu pour relier le module de batterie adjacent et est vissé dans un trou de montage (2111) de l'extrémité de sortie coudée (211).

7. Module de batterie selon l'une quelconque des revendications 1 à 6, dans lequel le support de fixation (1) comprend une pluralité de premiers éléments de butée (15) faisant saillie sur la première surface de fixation (11) et agencés pour s'emboîter par encliquetage avec les cellules (3).

8. Module de batterie selon l'une quelconque des revendications 1 à 6, dans lequel le support de fixation (1) comprend une pluralité de seconds éléments de butée (16) faisant saillie sur la seconde surface de fixation (12) et agencés pour emboîter par encliquetage l'ensemble de barres omnibus (2).
